# EUROPÄISCHE PATENTANMELDUNG

(11) **EP 3 330 175 A1**
(43) Veröffentlichungstag der Anmeldung: **06.06.2018**
(21) Anmeldenummer: 17204733.4
(22) Anmeldetag: 30.11.2017
(51) Int. Cl.: B64C 23/00, F15D 1/00

(54) **AKTUATOREN ZUR STRÖMUNGSKONTROLLE AN OBERFLÄCHEN AERODYNAMISCHER PROFILE**

(30) Priorität: 30.11.2016 DE 102016014246
(71) Anmelder: Airbus Defence and Space GmbH, 82024 Taufkirchen (DE); Airbus Operations GmbH, 21129 Hamburg (DE)
(72) Erfinder: CASPARI, Ralf, 85092 Kösching (DE); WEICHWALD, Robert, 93354 Siegenburg (DE); ERMANN, Emanuel, 85077 Oberstimm (DE); HELLER, Gerd, 21129 Hamburg (DE); KONIGORSKI, Detlev, 21129 Hamburg (DE); SCHNÄUBELT, Stefan, 21129 Hamburg (DE); JORDAN, Nicole, 21129 Hamburg (DE)
(74) Vertreter: LKGLOBAL Lorenz & Kopf PartG mbB Patentanwälte

(57) **Zusammenfassung**

Eine Baugruppe (F) zur Anbringung an der Oberfläche eines aerodynamischen Profils (P) weist einen Array aus Aktuatoren auf, die als Piezoaktuatoren und Plasmaaktuatoren ausgebildet sind.

## Beschreibung

Die Erfindung betrifft Aktuatoren der voranstehend angegebenen Art, die zur Strömungskontrolle ausgebildet sind, und zwar zur Kontrolle von Grenzflächen oder wandnahen Strömungen von an den Aktuatoren vorbeiströmenden Fluiden, insbesondere von Luft. Hierdurch lassen sich etwa die Eigenschaften aerodynamischer Profile, etwa von Tragflächen oder Steuerflächen von Luftfahrzeugen, insbesondere Flugzeugen, sowie etwa von Flügeln von Windkraftanlagen, auf verschiedene Arten und Weisen verändern und optimieren.

Von S. Grundmann et al., Plasma zur Strömungskontrolle, Wissenschaftsmagazin der TU Darmstadt, Herbst 2009, Seiten 64-67, wurde die Strömungskontrolle mittels PlasmaAktuatoren vorgeschlagen, die als DBD-Aktuatoren (DBD: dielectric barrier discharge; im deutschen Sprachgebrauch auch als DBE: dielektrische Barriereentladung bezeichnet) ausgebildet sind.

Die Beeinflussung des Strömungsflusses über Tragflächen von Flugzeugen wurde auch vorgeschlagen von R. Erfani et al., Development of DBD plasma actuators: The double encapsulated electrode, Acta Aeronautica 109 (2015), Seiten 132-143, ELSEVIER-Verlag. Dort werden DBD-Aktuatoren mit einer eingekapselten Elektrode (SDBD-Aktuator) oder mehreren eingekapselten Elektroden (MEE-Aktuatoren) beschrieben. Im einfachsten Fall eines SDBD-Aktuators ist eine freiliegende Elektrode vorgesehen, die an eine Hochspannungsversorgung (typischerweise im kV-Bereich) angeschlossen ist, die mit Wechselspannung (oder gepulst) betrieben wird (typischerweise mit Wechselspannung im kHz-Bereich).

Die freiliegende Elektrode ist oben auf einer Dielektrikumsschicht angeordnet, in deren Unterseite eine eingekapselte Elektrode vorgesehen ist, die elektrisch mit Masse verbunden ist. Der gesamte DBD-Aktuator ist auf einem Substrat angebracht.

Im Betrieb des DBD-Aktuators wird an der freiliegenden Elektrode aus der Umgebungsluft ein Plasma erzeugt, also ionisierte Luft, die aus Ionen und Elektronen besteht.

Weiterhin sind als Aktuatoren auch Piezoelemente bekannt, bei denen ein Plättchen aus einem piezoelektrischen Kristall oder einer piezoelektrischen Keramik zwischen zwei Elektroden eingeschlossen ist. Beim Anlegen einer elektrischen Spannung wird eine mechanische Bewegung hervorgerufen (Piezoaktuator, sog. inverser Piezoeffekt), oder es wird bei Einwirkung einer mechanischen Kraft eine elektrische Spannung zwischen den Elektroden erzeugt (Piezoeffekt).

Der Erfindung liegt die Aufgabe zugrunde Aktuatoren bereitzustellen, die eine weiten Einsatzbereich abdecken, der über die Strömungskontrolle hinaus weitere Einflussmöglichkeiten eröffnet.

Der Erfindung liegt zunächst die Erkenntnis zugrunde, dass zumindest einige derartige voranstehend angegebene Aktuatoren, aber auch entsprechend ausgebildete Sensoren, als sogenannte Mikrosysteme mit kleinsten Abmessungen im Mikrometerbereich ausgebildet sein können. International hat sich hierfür die Bezeichnung MEMS-Systeme durchgesetzt (MEMS: micro electro-mechanical systems).

Der Erfindung liegt weiterhin die Erkenntnis zugrunde, dass Aktuatoren bei geeigneter Ausbildung über die Strömungsbeeinflussung hinaus auch zur Reinigung der Oberfläche eines aerodynamischen Profils und/oder zur Messung lokaler aerodynamischer Parameter nutzbar sind.

Der Begriff "Reinigung von Oberflächen" ist dabei breit zu verstehen und umfasst beispielsweise über die eigentliche Reinigung auch die Ablösung von Verschmutzungen, das Verhindern von Anlagerungen an einer Oberfläche, oder etwa die Verhinderung oder Ablösung einer Eisablagerung auf einer Oberfläche.

Auch der Begriff "Einsatz als Sensoren zur Messung lokaler aerodynamischer Parameter" ist breit zu verstehen und umfasst beispielsweise die Messung von Druck- oder Scherkräften, von Strömungsrichtungen, Temperaturen oder Strömungszuständen.

Die Aufgabe wird gelöst durch eine Baugruppe mit MEMS-Aktuatoren mit den im Anspruch 1 angegebenen Merkmalen, wobei die Folie an der Oberfläche eines aerodynamischen Profils anbringbar ist. Vorteilhafte Ausgestaltungen der Erfindung sind in den abhängigen Ansprüchen angegeben.

Gemäß der Erfindung ist eine Baugruppe mit einem Array vorgesehen, der eine Kombination von Piezoelementen und DBD-Elementen (als Aktuatoren und/oder Messelemente ausgebildet bzw. eingesetzt) aufweist, wobei zumindest eine der beiden Arten von Aktuatoren (Piezo und DBD) in MEMS-Technik ausgeführt ist.

Zusätzlich können auf der Oberfläche der Baugruppe Oberflächenelemente, vorzugsweise mit bionischen, Strukturen vorgesehen sein, etwa in Form einer verrippten Struktur (sogenannte "Haifischhaut") zur Verringerung des Strömungswiderstands, oder zur Aufrechterhaltung einer minimalen Grenzschichtdicke. Andere bionische Strukturen können zur Erzielung eines Lotoseffektes dienen, um das Anhaften von Verschmutzungen zu verhindern oder zumindest zu minimieren.

Eine bionische Struktur kann auch dazu ausgebildet sein, die Energieeffizienz der Ionisierung des vorbeiströmenden Fluids zu erreichen, oder um den Verschleiß der Aktuatoren zu verringern.

Die Aktuatoren können auch als Sensoren eingesetzt werden. Hierzu werden ein oder mehrere Betriebsparameter gemessen, zum Beispiel der Betriebsstrom und/oder die Betriebsspannung. Hieraus lassen sich Rückschlüsse über etwa das Ausmaß der Verschmutzung oder Vereisung gewinnen.

Wird ein Piezo-Aktuator als Generator betrieben, so können über die Messung des Betriebsparameters der Leerlaufspannung Rückschlüsse auf aerodynamische Parameter ermöglicht werden.

Es können auch ein oder mehrere Paare von jeweils zwei miteinander gekoppelten PiezoAktuatoren vorgesehen sein. Der erste Piezo-Aktuator wird mit einem Elektrodenpaar zu Schwingungen angeregt. Der zweite Piezo-Aktuator ist mit dem ersten mechanisch gekoppelt und erzeugt aus den Schwingungen an einer seiner beiden Elektroden eine hohe elektrische Spannung (sogenannter "Piezotransformator"), die zur Ionisierung des vorbeiströmenden Fluids eingesetzt werden kann.

Die Erfindung wird nachstehend anhand zeichnerisch dargestellter Ausführungsbeispiele naher erläutert, aus denen weitere Vorteile und Merkmale hervorgehen. Es zeigt:
Figur 1 ein aerodynamisches Profil mit einer auf dessen Oberfläche angebrachter Folie;
Figur 2 einen Piezoaktuator mit einer bürstenartigen Struktur zur Erzielung eines Resonanzeffekts;
Figur 3 einen Piezoaktuator mit einer Anordnung aus Materialien mit unterschiedlichen Elastizitätsmodulen, um durch unterschiedliche Schwingungsdämpfung Scherkräfte zu erzeugen;
Figur 4 einen Piezoaktuator mit einer bürstenartigen Struktur zur Erzeugung von Longitudinalkräften;
Figur 5 einen Piezoaktuator mit einem eingebetteten harten Material wie etwa Keramik, um aus der Biegeschwingung des Piezoaktuators Scher- und Torsionskräfte zu erzeugen;
Figur 6 eine Baugruppe mit einem Array von 8 x 11 Aktuatoren auf der Oberseite;
Figur 7 eine schematische Darstellung eines Plasmaaktuators mit zwei Elektroden;
Figur 8 eine Baugruppe mit zwei Plasmaaktuatoren und einem auf der Oberseite angeordneten Piezoaktuator (Piezoelement);
Figur 9 eine Baugruppe mit einem Array Oberflächenelementen aus drei verschiedenen Materialien;
Figur 10 eine Baugruppe mit zwei Plasmaaktuatoren und einem Piezoaktuator;
Figur 11 eine schematische Darstellung eines Plasmaaktuators, wobei die obere Elektrode gleichzeitig ein Piezoelement darstellt;
Figur 12 eine Baugruppe mit einem Plasmaaktuator und einem Piezoaktuator sowie mit einem Array aus Oberflächenelementen aus drei unterschiedlichen Materialien;
Figur 13 eine Schnittansicht einer Baugruppe mit MEMS-Plasmaaktuatoren (DBD-Elementen) in koplanarer Anordnung, wobei sich DBD-Elemente mit Piezoaktuatoren abwechseln;
Figur 14 eine Schnittansicht einer Baugruppe mit koplanaren (mikroskopischen, also MEMS) DBD-Elementen und makroskopischen Piezoaktuatoren an der Unterseite; und
Figur 15 eine Schnittansicht einer Baugruppe mit miniaturisierten (mikroskopischen) koplanaren DBD-Elementen und makroskopischen Piezoaktuatoren an der Unterseite, wobei an der Oberseite der Baugruppe eine Anordnung von Materialien mit unterschiedlichen akustischen Eigenschaften vorgesehen ist.

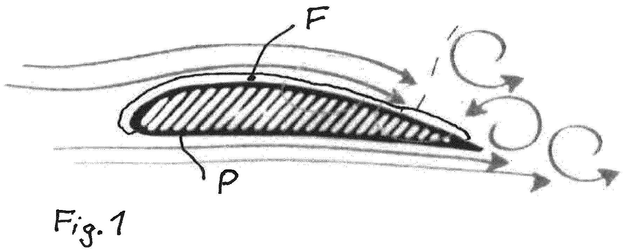

In Figur 1 ist ein aerodynamisches Profil P mit einer Folie F dargestellt, in die eine erfindungsgemäße Baugruppe mit Plasmaaktuatoren und Piezoaktuatoren eingebettet ist Der Fluss einer umströmenden Luftströmung ist durch Pfeile verdeutlicht.

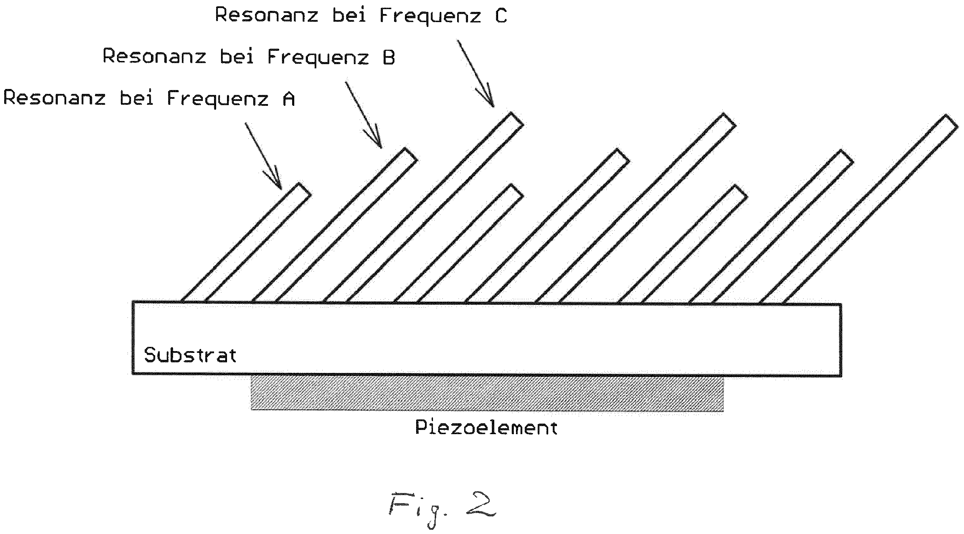

Figur 2 zeigt eine Baugruppe mit einem Piezoaktuator. Auf der Oberfläche eines Substrats sind Oberflächenelemente vorgesehen, die unterschiedliche Resonanzfrequenzen A, B und C aufweisen.

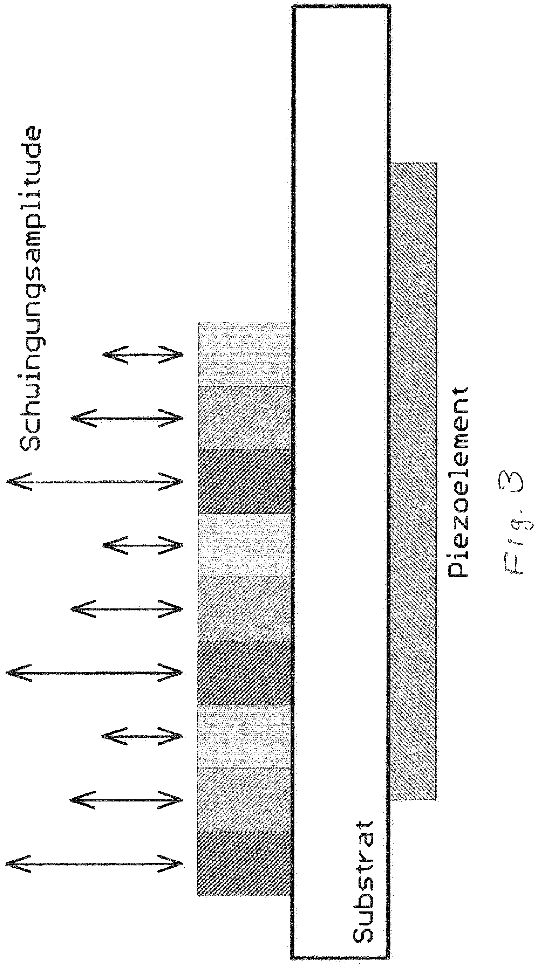

Bei der in Figur 3 dargestellten Baugruppe ist ein Piezoaktuator unterhalb eines Substrats vorgesehen, an dessen Oberfläche Oberflächenelemente aus unterschiedlichen Materialien vorhanden sind, die entsprechend unterschiedliche Schwingungsamplituden aufweisen, wenn sie durch den Aktuator angeregt werden.

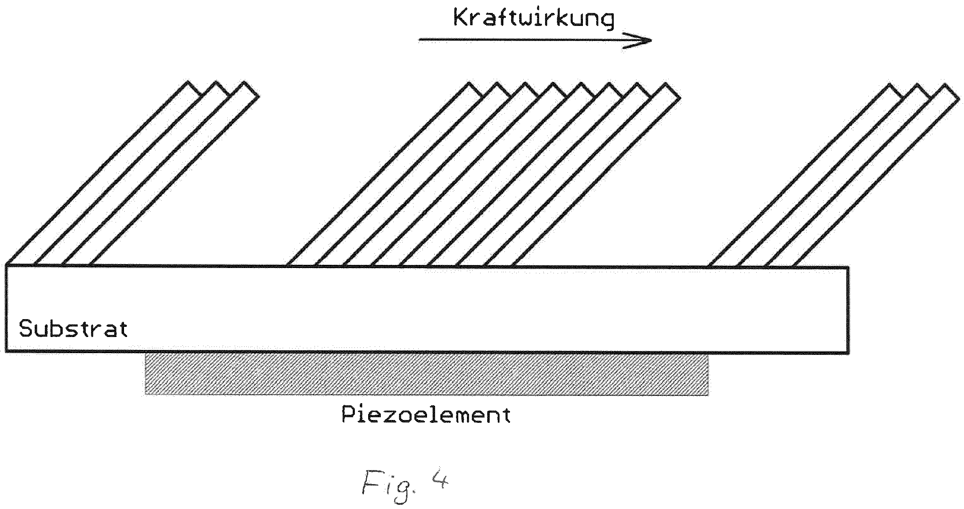

Eine ähnliche Baugruppe ist in Figur 4 dargestellt, wobei jedoch Gruppen von Oberflächenelementen zur Erzielung einer Kraftwirkung in Longitudinalrichtung (Richtung des Pfeils) vorgesehen sind.

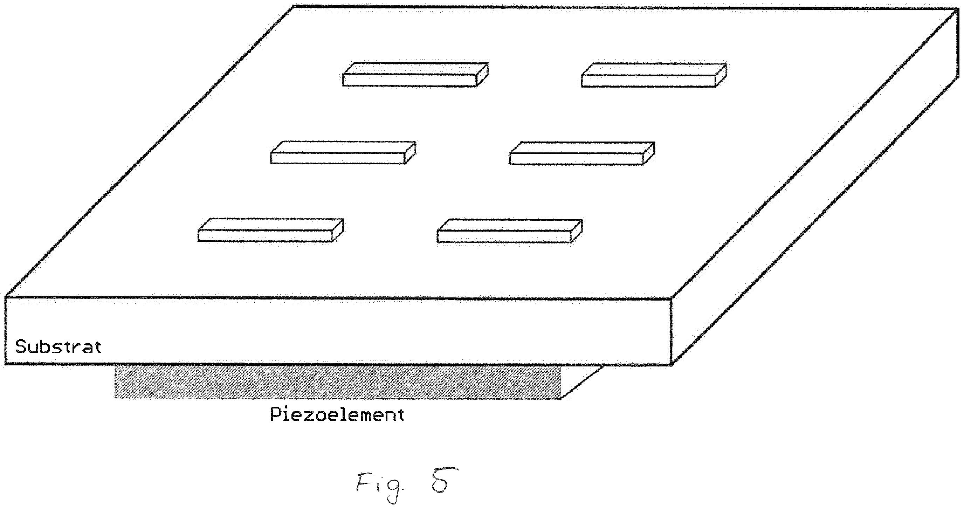

Bei der Baugruppe von Figur 5 sind in die Oberfläche sechs stabförmige Keramikbauteile eingebettet.

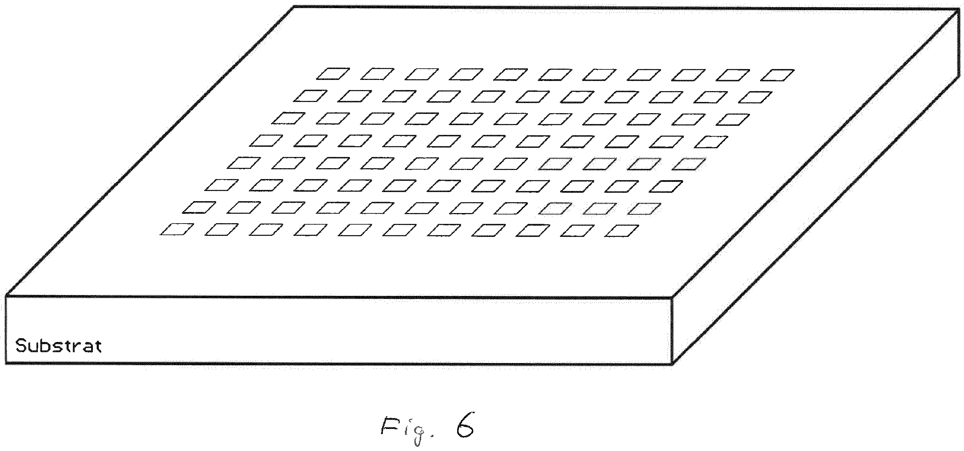

Figur 6 zeigt eine Baugruppe mit einem regelmäßigen Array von 6 x 8 Aktuatoren (Piezo- und Plasmaaktuatore),

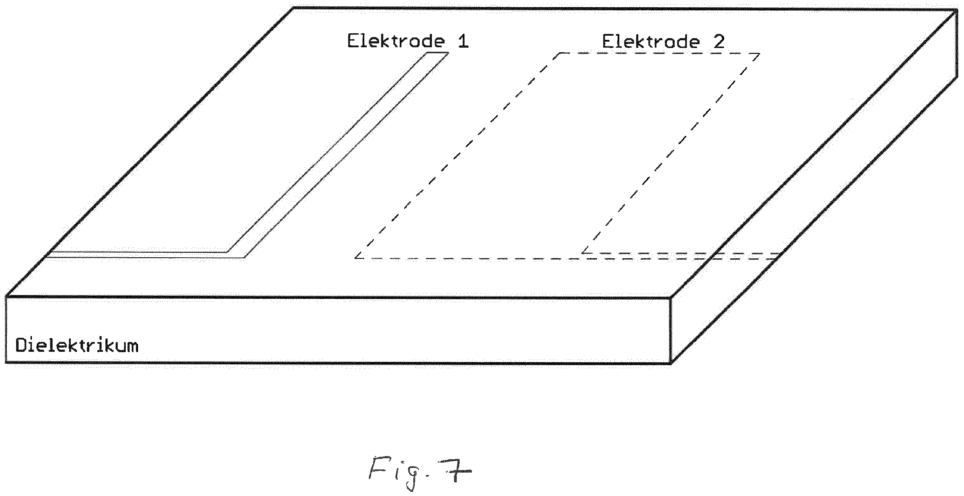

Figur 7 zeigt schematische einen Plasmaaktuator (DBD-Aktuator) mit einem Dielektrikum und zwei Elektroden, wobei Elektrode 1 an der Oberseite und Elektrode 2 an der Unterseite vorgesehen ist.

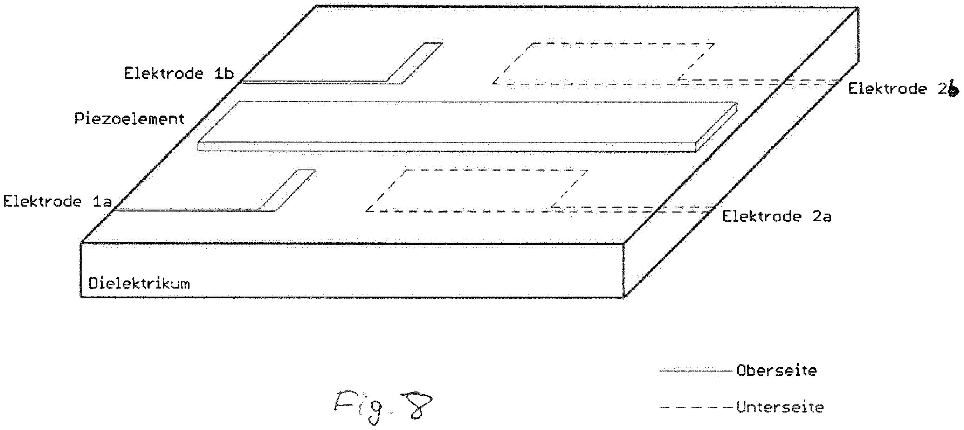

Bei der in Figur 8 gezeigten Baugruppe sind zwei Plasmaaktuatoren (mit Elektroden 1a, 2a beziehungsweise 1b, 2b) vorhanden. Weiterhin ist auf der Oberseite des Dielektrikums ein Piezoaktuator vorhanden.

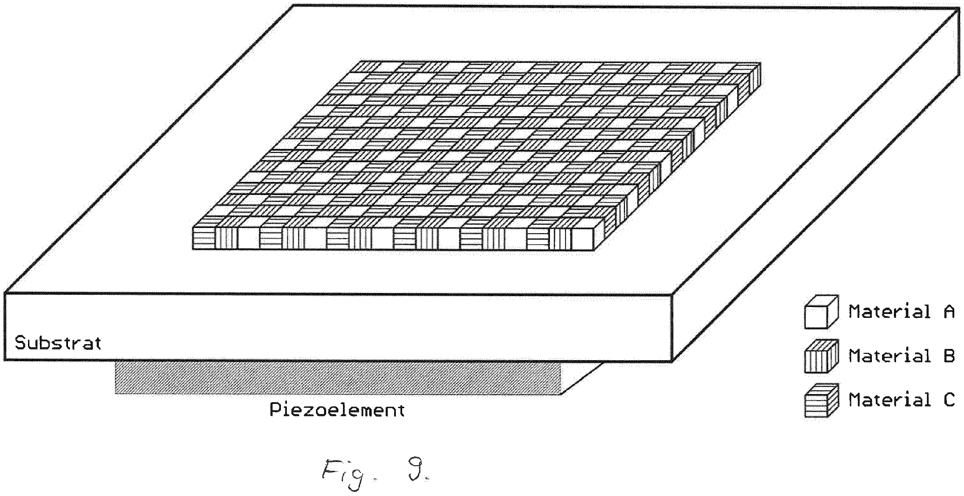

Figur 9 zeigt eine Baugruppe mit einem an der Unterseite eines Substrats vorgesehenen Piezoaktuator, wobei auf der Oberfläche des Substrats ein regelmäßiger Array aus drei unterschiedlichen Materialien A, B und C mit unterschiedlichen Schwingungseigenschaften oder akustischen Eigenschaften ausgebildet ist.

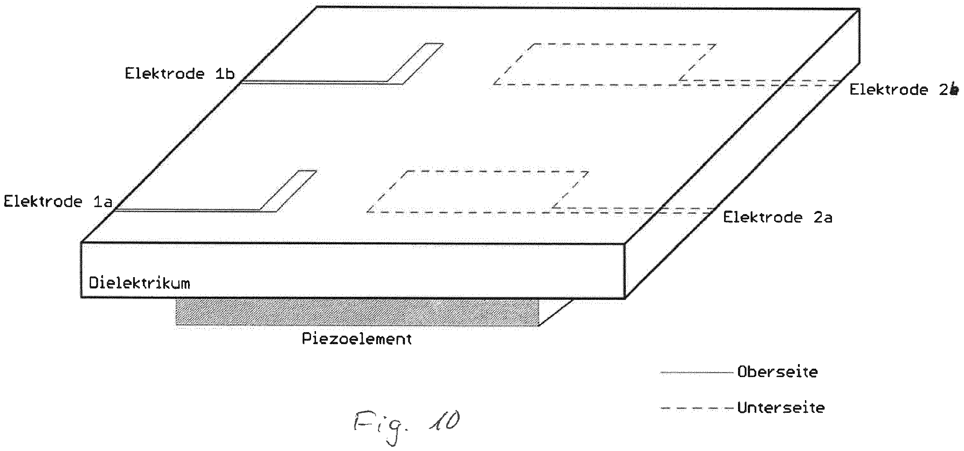

Figur 10 zeigt eine Baugruppe mit zwei Plasmaaktuatoren (Elektroden 1a, 2a beziehungsweise 1b, 2b) sowie mit einem Piezoaktuator an der Unterseite.

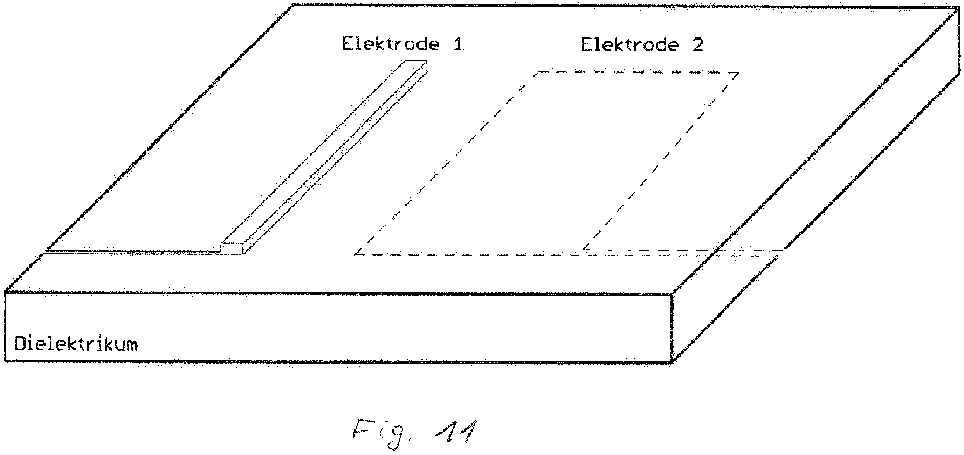

Figur 11 zeigt eine schematische Darstellung eines Plasmaaktuators mit zwei Elektroden 1 und 2, wobei die Elektrode 1 gleichzeitig ein Piezoelement darstellt (angedeutet durch eine Verdickung der Elektrode 1).

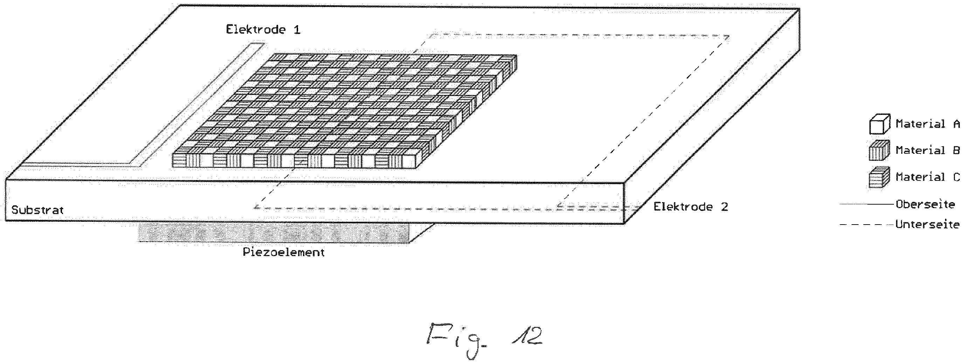

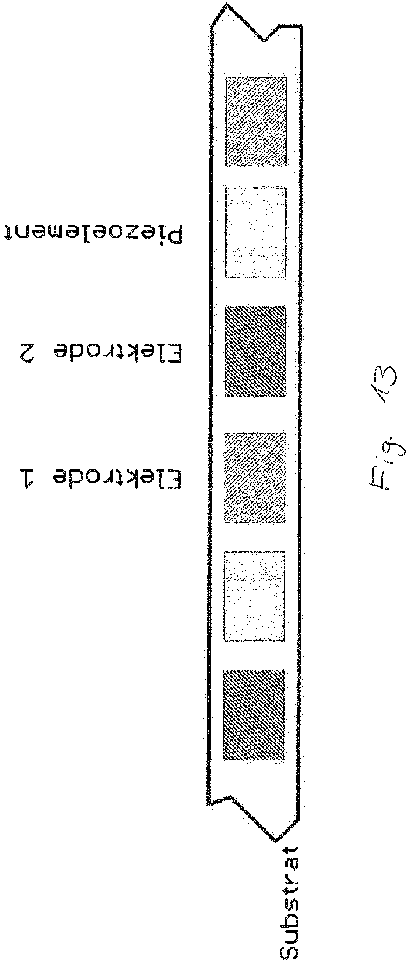

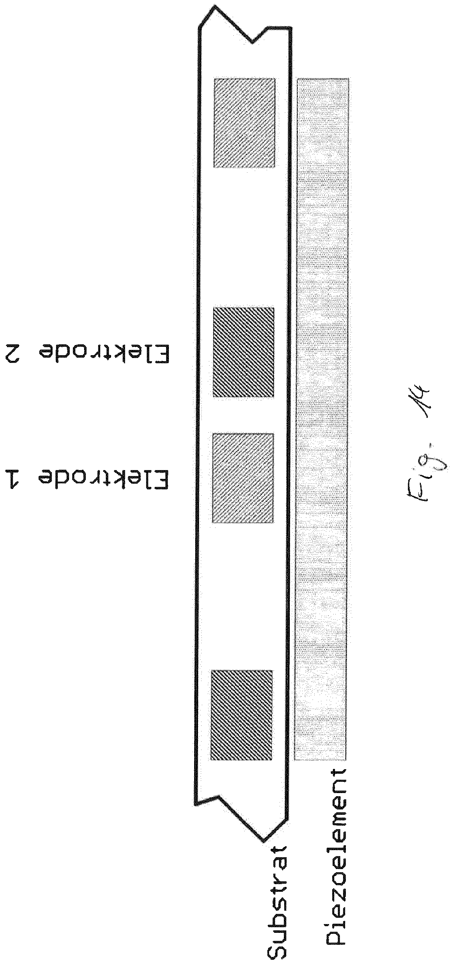

Die Figuren 12, 13 und 14 wurden bereits voranstehend erläutert.

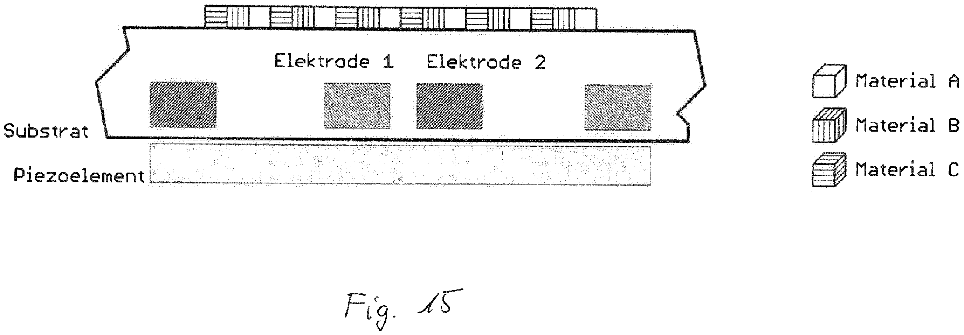

Figur 15 zeigt eine Baugruppe mit einem Plasmaaktuator (Elektroden 1 und 2) und einem Piezoaktuator an der Unterseite. Auf der Oberfläche ist ein regelmäßiger Array aus drei unterschiedlichen Materialien A, B und C mit unterschiedlichen Eigenschaften (etwa akustischen oder Schwingungseigenschaften) vorhanden.

## Patentansprüche

1. Baugruppe (F) zur Anbringung in oder an der Oberfläche eines aerodynamischen Profils (P), wobei die Baugruppe einen Array aus Aktuatoren aufweist, die als Piezoaktuatoren und Plasmaaktuatoren ausgebildet sind, wobei an einer Oberfläche der Baugruppe Oberflächenelemente vorgesehen sind.

2. Baugruppe nach Anspruch 1, wobei die Plasmaaktuatoren miniaturisiert (MEMS) ausgebildet sind.

3. Baugruppe nach Anspruch 2, wobei die Plasmaaktuatoren als SDBD- oder als MEE-Aktuatoren ausgebildet sind.

4. Baugruppe nach einem der Ansprüche 1 bis 3, wobei der Array zumindest 10000 Aktuatoren pro Quadratmeter aufweist.

5. Baugruppe nach einem der Ansprüche 1 bis 4, wobei die Oberflächenelemente eine bionische Struktur aufweist.

6. Folie nach einem der Ansprüche 1 bis 5, wobei die Oberflächenelemente aus unterschiedlichen Materialien mit unterschiedlichen Eigenschaften bestehen.

7. Baugruppe nach einem der Ansprüche 1 bis 6, wobei zumindest ein Paar von zwei mechanisch miteinander gekoppelten Piezoaktuatoren zur Ausbildung eines Piezotransformators vorgesehen ist.

8. Baugruppe nach einem der Ansprüche 1 bis 7, wobei einzelne, unterschiedliche Aktuatortypen wiederholt nebeneinander in Form eines Arrays angeordnet sind (Aktuator A neben Aktuator B, neben Aktuator C, neben Aktuator A, usw.). Möglich ist auch eine Anordnung von Gruppen gleichartiger Aktuatortypen nebeneinander, (als Schachbrettmuster bei zwei Aktuatortypen bzw. abwechselnd bei drei oder mehr Aktuatortypen).

9. Aerodynamisches Profil (P) mit einer auf dessen Oberfläche angebrachten Baugruppe (F) nach einem der Ansprüche 1 bis 8.

10. Verwendung des Profils (P) zur Verhinderung oder Ablösung einer Anhaftung wie etwa Verschmutzung oder Eis.

11. Verfahren zur Messung zumindest eines Betriebsparameters von zumindest einem der Aktuatoren der Baugruppe nach einem der Ansprüche 1 bis 8.
